# DEMANDE DE BREVET EUROPEEN

(11) **EP 4 709 097 A1**
(43) Date de publication de la demande: **11.03.2026**
(21) Numéro de dépôt: 25198926.5
(22) Date de dépôt: 29.08.2025
(51) Int. Cl.: H10F 19/80

(54) **MODULE PHOTOVOLTAÏQUE**

(30) Priorité: 05.09.2024 FR 2409442
(71) Demandeur: Commissariat à l'Energie Atomique et aux Energies Alternatives, 75015 Paris (FR)
(72) Inventeur: PERROTIN, Louis, 38054 GRENOBLE CEDEX 09 (FR); CHARPENTIER, Jean-Baptiste, 38054 GRENOBLE CEDEX 09 (FR); JAMIN, Clément, 38054 GRENOBLE CEDEX 09 (FR); CARIOU, Romain, 38054 GRENOBLE CEDEX 09 (FR)
(74) Mandataire: Ipsilon

(57) **Abrégé**

Module photovoltaïque (M) comportant une face avant (1) et une face arrière (3) entre lesquelles est disposé un encapsulant (2) de cellules photovoltaïques (20),
le module (M) comportant une pluralité de guirlandes chacune d'une ou plusieurs cellules photovoltaïques (20), la ou les cellules photovoltaïques (20) d'une guirlande étant placées en série selon un axe longitudinal de la guirlande,
le module (M) comportant en outre une pluralité (10) de raidisseurs (11, 12) disposés entre la face avant (1) et la face arrière (3),
la pluralité (10) de raidisseurs comportant au moins un raidisseur longitudinal (11) placé entre les guirlandes de cellules photovoltaïques (20), de manière à s'étendre longitudinalement entre deux guirlandes de cellules photovoltaïques (20) et un ou des raidisseurs transversaux (12) disposés entre une ou des guirlandes et un bord du module photovoltaïque. Au moins un raidisseur longitudinal et/ou un des raidisseurs transversaux dépasse du module, permettant ainsi de faciliter la fixation du module photovoltaïque à une structure d'attache (40).

## Description

### Domaine technique

La présente invention concerne un module photovoltaïque et un procédé de fabrication d'un tel module photovoltaïque. Le module photovoltaïque comporte au moins une cellule photovoltaïque noyée dans un ensemble encapsulant comportant un matériau polymère et deux faces externes contenant un matériau polymère ou du verre.

### Technique antérieure

Un module photovoltaïque comporte des cellules photovoltaïques destinées à convertir une énergie radiative ou lumineuse en énergie électrique. Un tel module photovoltaïque peut être soumis lors de son utilisation, par exemple dans l'espace, à de fortes contraintes thermiques, notamment avec des cycles de forte amplitude en température. De telles contraintes thermiques peuvent induire des déformations tels que des fléchissements et des ondulations, qui sont préjudiciables à la planéité du module photovoltaïque ainsi qu'à ses performances à long terme.

On connait par exemple par la demande internationale WO 2017/085017 l'utilisation d'une face arrière légère et très rigide. Cette face arrière est composée d'une âme en nid d'abeille et de faces externes en matériaux composites. Elle est accompagnée d'une couche isolante, permettant de l'isoler électriquement du reste du module. Cette face arrière recouvre toute la surface du module et est mise en forme au moment de la lamination du module photovoltaïque. La réduction de poids est limitée.

La demande internationale WO 2013/074224 reprend le même principe avec une âme en mousse, ce qui ne permet pas de réduire davantage le poids de la face arrière.

La demande FR 3 138 001 présente une rigidification du module photovoltaïque par l'ajout d'un cadre en composite à l'extérieur de la face arrière. Ce cadre peut être composé d'une seule couche de matériau composite ou bien d'une structure sandwich avec âme en nid d'abeille ou creuse et des faces externes en matériau composite.

Enfin, la demande internationale WO 2023/199005 met en œuvre un cadre sur le pourtour du module, cadre qui peut être en composite ou en structure sandwich analogue à celles décrites précédemment. Ce cadre est intégré au module lors de la lamination.

Dans les deux derniers documents cités, on n'obtient pas une rigidification locale du module, mais seulement de son pourtour. La partie du module entre deux guirlandes de cellules peut rester flexible et être toujours sujette aux ondulations et fléchissements.

Aussi, il existe un besoin pour renforcer mécaniquement encore les modules photovoltaïques.

Par ailleurs, il existe un besoin pour disposer de modules photovoltaïques très légers, notamment pour certaines applications terrestres ou extraterrestres.

Enfin, il existe également un besoin pour réduire le coût des modules photovoltaïques pour certaines applications terrestres ou extraterrestres.

### Résumé de l'invention

La présente invention répond à tout ou partie de ce besoin et a ainsi pour objet un module photovoltaïque, comportant une face avant et une face arrière entre lesquelles est disposé un ensemble encapsulant des cellules photovoltaïques,
le module comportant une pluralité de guirlandes chacune d'une ou plusieurs cellules photovoltaïques, la ou les cellules photovoltaïques d'une guirlande étant placées en série selon un axe longitudinal de la guirlande,
le module comportant en outre une pluralité de raidisseurs disposés entre la face avant et la face arrière,
la pluralité de raidisseurs comportant au moins un raidisseur longitudinal placé entre les guirlandes de cellules photovoltaïques, de manière à s'étendre longitudinalement entre deux guirlandes de cellules photovoltaïques.

La pluralité de raidisseurs peut comporter notamment plusieurs raidisseur longitudinaux placés entre les guirlandes de cellules photovoltaïques, de manière à s'étendre longitudinalement chacun entre deux guirlandes de cellules photovoltaïques.

La présence des raidisseurs permet de renforcer la rigidité du module photovoltaïque, en particulier localement, notamment autour des cellules photovoltaïques. Les raidisseurs permettent de diminuer le fléchissement lors du cyclage thermique d'un module photovoltaïque, principalement entre les cellules photovoltaïques. Ainsi, le module photovoltaïque selon l'invention peut être moins sujet à des ondulations ou fléchissements lors d'un cyclage thermique, notamment spatial.

Le module photovoltaïque selon l'invention peut notamment être configuré pour résister à plusieurs milliers de cycles thermiques allant de + 120°C à -120°C, par exemple à pression atmosphérique ou par exemple à pression nulle. Un cycle peut être d'une durée par exemple d'environ typiquement 1h30.

Par 'guirlande de cellules photovoltaïques', on entend un ensemble d'une ou plusieurs cellules photovoltaïques, les cellules photovoltaïques étant branchées en série dans la guirlande. Une guirlande peut ne comporter qu'une seule cellule photovoltaïque. Une guirlande de cellules photovoltaïques s'étend selon un axe longitudinal de la guirlande, les cellules photovoltaïques de la guirlande se succédant le long de cet axe longitudinal, qui forme ainsi un grand axe pour la guirlande.

### Exposé de l'invention

### Module photovoltaïque

Le module photovoltaïque en tant que tel comporte une ou des cellules photovoltaïques disposées entre une face avant et une face arrière séparée par une tranche du module photovoltaïque, et qui sont reliées électriquement entre elles par des conducteurs de liaison et qui sont immergées entre deux couches avant et arrière de matériau d'encapsulation formant toutes les deux l'ensemble encapsulant.

Le module photovoltaïque peut comporter notamment au moins :
- une première couche de protection transparente formant la face avant, par exemple en verre, ou encore par exemple réalisée en au moins un matériau polymère, par exemple à base de polymères multi-couches,
- un ensemble encapsulant formé par au moins une couche comportant au moins un matériau d'encapsulation de type polymère, par exemple de type élastomère transparent, dans lequel sont encapsulées ou enrobées des cellules photovoltaïques, et
- une deuxième couche de protection formant la face arrière du module photovoltaïque, par exemple en verre également, ou encore par exemple réalisée en au moins un matériau polymère, par exemple à base de polymères multi-couches définissant une face arrière non transparente, dite *« backsheet ».*

La première couche de protection transparente et la deuxième couche de protection permettent de protéger le module des attaques extérieures et éventuellement de le rigidifier, notamment dans le cas où elle(s) sont en verre.

La première couche de protection transparente peut ne pas être en verre, mais par exemple à base d'un ou plusieurs matériaux polymères. Elle peut ainsi être avantageusement plus légère. Le ou les polymères peuvent être choisis dans la liste suivante, qui n'est pas limitative : ETFE, ECTFE, PVDF, PU, PC, PI, PEEK, PET, PA.

La présence des raidisseurs permet de bien rigidifier le module photovoltaïque, même en présence d'une ou deux couches de protection à base de polymère, moins rigides que le verre.

Le module photovoltaïque peut être dépourvu d'une couche de protection en verre. Il peut ne comporter aucune couche de protection en verre.

Le module photovoltaïque comporte en outre une interconnexion composée d'une part de fils ou rubans, qui permettent de connecter les cellules photovoltaïques en série et joue le rôle « d'autoroute » à électrons. L'ensemble des cellules connectées entres elles par des fils ou rubans est appelé guirlande ou *« string »* en anglais ; et d'autre part d'une brasure qui assure un bon contact mécanique et électrique entre le fil et la cellule. Cette brasure peut être réalisée en continue sur tout le fil, ou localement, par plot.

On peut définir des bords du module photovoltaïque, qui définissent son pourtour, étant formés par les bords des faces avant et face arrière et de l'ensemble encapsulant. On peut définir deux bords opposés, le module photovoltaïque pouvant avoir une forme générale rectangulaire. Les bords peuvent avoir une certaine épaisseur, du fait de la présence des cellules photovoltaïques dans l'ensemble encapsulant, de sorte qu'on peut définir des arêtes des bords au niveau des arrêtes supérieures et inférieures, de part et d'autre de la tranche du module photovoltaïque.

### Ensemble encapsulant

L'ensemble encapsulant peut être formé à partir d'au moins un film avant et un film arrière comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

Par le terme « ensemble encapsulant » ou « encapsulé », il faut comprendre que la pluralité de cellules photovoltaïques est disposée dans un volume, par exemple hermétiquement clos vis-à-vis des liquides et des gaz, au moins en partie formé par au moins deux films de matériau(x) d'encapsulation, réunies entre eux après lamination pour former l'ensemble encapsulant.

En effet, initialement, c'est-à-dire avant toute opération de lamination, l'ensemble encapsulant est constitué par au moins deux films de matériau(x) d'encapsulation, entre lesquels la pluralité de cellules photovoltaïques est encapsulée.

Toutefois, pendant l'opération de lamination des films, les films de matériau d'encapsulation fondent pour ne former, après l'opération de lamination, qu'un seul ensemble solidifié dans lequel sont noyées ou enrobées les cellules photovoltaïques.

Un module photovoltaïque peut comporter deux couches de protection, une première couche de protection formant par exemple la face avant et réalisée dans un ou des matériaux transparents choisi dans la liste suivante, qui n'est pas limitative : verre, matériau composite, matière plastique, polymère. Un module photovoltaïque peut comporter une deuxième couche de protection formant la face arrière et réalisée dans un ou des matériaux choisis dans la liste suivante, qui n'est pas limitative : verre, matériau composite, matière plastique, polymère, métaux. Dans le cas où les première et deuxième couches de protection sont réalisées en verre, on parle de module biverre. En variante, les première et deuxième couches de protection peuvent être réalisées en matériau composite, matière plastique, ou polymère.

### Raidisseurs

Par 'raidisseur', on entend un élément allongé de type poutre, très rigide en flexion.

La pluralité de raidisseurs peut comporter au moins un raidisseur longitudinal, voire plusieurs raidisseurs longitudinaux de la pluralité de raidisseurs, qui peuvent s'étendre longitudinalement selon l'axe longitudinal de la guirlande, notamment de la guirlande adjacente audit raidisseur.

Le module peut être dépourvu de raidisseur au-dessus d'une cellule photovoltaïque, de façon à éviter le risque d'endommagement d'une cellule photovoltaïque lors la lamination du module au cours de sa fabrication.

Un ou des raidisseurs parmi la pluralité de raidisseurs peuvent être disposés entre la face avant et l'ensemble encapsulant, notamment un ou des raidisseurs longitudinaux parmi la pluralité de raidisseurs peuvent être disposés entre la face avant et l'ensemble encapsulant.

Des raidisseurs, notamment des raidisseurs longitudinaux, sont avantageusement placés du côté de la face avant, cela permettant de faciliter le procédé de fabrication, notamment la lamination, laquelle peut être réalisée en une seule étape de lamination. Ils peuvent notamment être placés dans l'ensemble encapsulant, entre la face avant et la ou les cellules photovoltaïques.

Un ou des raidisseurs parmi la pluralité de raidisseurs peuvent être disposés entre l'ensemble encapsulant et la face arrière, notamment un ou des raidisseurs longitudinaux parmi la pluralité de raidisseurs peuvent être disposés entre l'ensemble encapsulant et la face arrière. Ils peuvent notamment être placés dans l'ensemble encapsulant, entre la face arrière et la ou les cellules photovoltaïques.

Dans un mode de réalisation, le module photovoltaïque peut comporter d'une part un ou des raidisseurs disposés entre la face avant et l'ensemble encapsulant et d'autre part un ou des raidisseurs disposés entre l'ensemble encapsulant et la face arrière.

Un ou des raidisseurs, notamment longitudinaux, parmi le ou les raidisseurs, notamment longitudinaux, disposés entre l'ensemble encapsulant et la face arrière peuvent être superposés avec le ou les raidisseurs, notamment longitudinaux, disposés entre la face avant et l'ensemble encapsulant. Ainsi, les raidisseurs, notamment longitudinaux, peuvent être empilés les uns sur les autres. Un raidisseur disposé entre l'ensemble encapsulant et la face arrière peut être placé en regard d'un raidisseur disposé entre la face avant et l'ensemble encapsulant. Une telle configuration avec empilement des raidisseurs les uns sur les autres permet de mieux renforcer mécaniquement le module photovoltaïque.

Les raidisseurs, notamment longitudinaux, peuvent être disposés de manière symétrique les uns des autres par rapport à un plan de symétrie passant par l'ensemble encapsulant.

Le module photovoltaïque peut comporter une couche de renforcement, notamment en matériau composite, disposés entre l'ensemble encapsulant et la face arrière. La présence additionnelle de cette couche de renforcement permet d'améliorer la rigidité du module photovoltaïque.

Un écartement maximal e entre les raidisseurs et la couche de renforcement peut être compris entre 0 mm inclus et 5 mm, voire entre 0 mm exclus et 1 mm, mieux entre 100 µm et 500 µm, étant par exemple d'environ 300 µm. Il peut être avantageux de maximiser cet écartement e afin d'améliorer encore la rigidité du module photovoltaïque.

La couche de renforcement peut comporter une forte rigidité en tension, par exemple de l'ordre de 10 GPa au moins. La couche de renforcement peut être configurée pour conserver ses propriétés mécaniques jusqu' à une température d'au moins 120°C, mieux d'au moins 140°C, voire d'au moins 160°C. La couche de renforcement peut avoir un coefficient de dilatation thermique inférieur à 2.10-5 K-1, voire inférieur à 1,5.10-5 K-1, voire encore inférieur à 1.10-5 K-1. La couche de renforcement peut avoir une épaisseur comprise entre 10 µm et 1000 µm, voire comprise entre 20 µm et 800 µm, voire encore comprise entre 30 µm et 600 µm, étant notamment d'environ 50 µm.

La couche de renforcement peut comporter des fibres noyées dans une matrice. Les fibres peuvent par exemple être choisies dans la liste suivante, qui n'est pas limitative : fibres de verre, fibres de carbone, fibres naturelles, par exemple chanvre, lin, basalte, fibres de carbure de silicium, fibres de polyester. La matrice peut par exemple être choisie dans la liste suivante, qui n'est pas limitative : matière plastique, par exemple parmi le polyuréthane (PU), le polypropylène (PP), l'époxy, le polycarbonate (PC), le polyméthacrylate de méthyle (PMMA), le polytéréphtalate d'éthylène (PET), le polyamide (PA), une colle acrylique, de la silicone, une colle époxy, un polymère fluoré, notamment le polyfluorure de vinyle (PVF), le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE) et/ou l'éthylène propylène fluoré (FEP). Le ou les matériaux pour les fibres et/ou la matrice peuvent être analogues ou identiques aux matériaux choisis pour le ou les raidisseurs, notamment de la même famille, comme décrit ci-après.

La couche de renforcement peut être avantageusement intégrée en une seule étape dans le procédé de fabrication.

La couche de renforcement peut être lisse, étant notamment dépourvue de relief. Elle peut être en particulier dépourvue de barreaux.

La couche de renforcement peut être opaque. Son emplacement en face arrière peut de ce fait être avantageux.

Le ou les raidisseurs, notamment le ou les raidisseurs longitudinaux, peuvent dépasser ou ne pas dépasser de l'ensemble encapsulant.

Le dépassement des raidisseurs peut permettre de faciliter la fixation du module photovoltaïque à une structure d'attache, formant ainsi des zones de fixation préférentielles. Une portion d'un raidisseur dépassant de l'ensemble encapsulant peut servir de point d'attache à la structure d'attache. Une telle configuration peut permettre d'éviter la présence d'un cadre. Le module photovoltaïque peut être dépourvu d'un cadre. Les raidisseurs peuvent être fixés à la structure d'attache par boulonnage, rivetage, serrage par pince ou collage, en particulier par rivetage. Le rivetage peut conférer une meilleure tenue au cyclage thermique spatial et permettre d'avoir un peu de jeu afin de laisser le module photovoltaïque se dilater ou se contracter lors des cyclages thermiques.

En variante, le ou les raidisseurs peuvent ne pas dépasser de l'ensemble encapsulant. Cela peut permettre un gain en poids pour le module photovoltaïque.

Le dépassement peut être d'une longueur 12 comprise entre 0 inclus et 200 mm, voire entre 0 exclu et 180 mm, voire encore entre 1 mm et 160 mm, mieux entre 2 et 140 mm, voire encore mieux entre 5 et 120 mm, étant par exemple d'environ 50 mm.

La largeur d'un raidisseur peut varier dans la portion qui dépasse de l'ensemble encapsulant, la largeur peut notamment augmenter. On définit alors 13 la largeur du raidisseur hors de l'ensemble encapsulant. Cette largeur 13 peut varier entre 2 cm et 15 cm, mieux entre 3 et 13 cm, voire entre 4 et 10 cm, étant par exemple d'environ 5 cm. L'augmentation de la largeur peut se faire via différentes géométries, notamment un angle droit, un biseau ou un congé.

Le module photovoltaïque peut comporter un ou plusieurs raidisseurs transversaux disposés transversalement aux guirlandes de cellules photovoltaïques. Le ou les raidisseurs transversaux peuvent se situer entre les rangées de guirlandes, suivant la perpendiculaire à leur axe longitudinal.

Le ou les raidisseurs transversaux peuvent être reliés aux raidisseurs longitudinaux. Ils peuvent permettre de relier entre eux les raidisseurs longitudinaux. Les raidisseurs transversaux et longitudinaux peuvent former une grille de raidissement du module photovoltaïque.

Le ou les raidisseurs transversaux peuvent dépasser ou ne pas dépasser de l'ensemble encapsulant, notamment comme décrit ci-dessus.

Les raidisseurs transversaux peuvent ne pas être en contact les uns avec les autres. Les raidisseurs longitudinaux peuvent ne pas être en contact les uns avec les autres.

Le module photovoltaïque peut comporter un ou des raidisseurs longitudinaux et/ou transversaux disposés entre une ou des guirlandes et un bord du module photovoltaïque. Cette configuration permet d'ajouter deux raidisseurs longitudinaux et/ou transversaux sur les bords latéraux, supérieur et inférieur du module, de sorte que les raidisseurs peuvent couvrir tous les espaces entre les guirlandes ainsi que le pourtour du module. Le module est ainsi plus rigide.

Avec cette configuration, les raidisseurs peuvent dépasser du module afin de constituer des zones de fixations privilégiées, comme décrit plus haut. L'ajout de deux raidisseurs transversaux sur les bords supérieur et inférieur du module permet d'ajouter quatre dépassements, et donc quatre zones de fixations. Cette configuration permet donc d'avoir une meilleure tenue du module vis-à-vis de la structure d'attache.

Afin de de prévenir un maximum le risque de fléchissement ou d'ondulation du module photovoltaïque, les raidisseurs peuvent de préférence combler la quasi-totalité de l'espace entre les guirlandes. Ainsi, une distance d1 entre une guirlande et le raidisseur adjacent, mesurée dans le plan du module photovoltaïque, peut être comprise entre 0 mm et 10 mm, voire entre 0,5 mm et 8 mm, voire encore entre 1 mm et 3 mm.

De même, le débord du module photovoltaïque autour des guirlandes sur le pourtour de celles-ci peut de préférence être minimisé. Ainsi, une distance d2 entre le bord du module photovoltaïque et les bords de guirlandes ou des raidisseurs longitudinaux d'extrémité peut être comprise entre 0,5 mm et 20 mm, voire entre 0,7 mm et 15 mm, voire encore entre 0,8 mm et 10 mm voire encore mieux entre 0,9 et 8 mm, étant par comprise entre 1 mm et 4 mm.

Ainsi, la quasi-totalité de la surface du module photovoltaïque peut être recouverte de surfaces rigides, cellules photovoltaïques ou raidisseurs. Avec un débord aussi faible des différentes couches du module photovoltaïque, les interconnexions de sorties des guirlandes peuvent être à l'air libre.

La largeur 11 d'un raidisseur peut être comprise entre 2 mm et 50 mm, mieux entre 4 mm et 45 mm, voire entre 6 mm et 40 mm, voire encore entre 8 mm et 35 mm, étant par exemple comprise entre 10 et 30 mm, étant notamment d'environ 20 mm.

La largeur 11 d'un raidisseur est avantageusement suffisamment importante pour permettre aux raidisseurs d'apporter de la rigidité au module photovoltaïque, sans toutefois faire perdre une trop grande surface aux cellules photovoltaïques. La surface occupée par les raidisseurs peut ne pas excéder 50% de la surface du module photovoltaïque.

Un raidisseur, longitudinal ou transversal, peut avoir une forme générale allongée.

En section transversale, il peut être de forme générale polygonale, rectangulaire, triangulaire, circulaire, semi-circulaire, elliptique, squircles, triangle de Reuleaux, cette liste n'étant pas limitative. Une forme allant en s'amincissant en section transversale peut permettre de faciliter l'insertion du raidisseur et son intégration dans le module photovoltaïque. En effet, une telle forme peut permettre que la face avant ou arrière fasse bien le tour du raidisseur, ce qui apporte un adoucissement de la transition entre les parties avec et sans raidisseurs et une meilleure répartition des contraintes.

Un raidisseur peut comporter une âme, notamment une âme réalisée dans un matériau léger, l'âme étant notamment recouverte en tout ou en partie d'un revêtement, notamment un revêtement dans un matériau composite.

Un raidisseur est de préférence léger, afin de ne pas trop augmenter le poids du module photovoltaïque. L'âme peut être réalisée dans un matériau léger, ce qui peut permettre d'accroître la rigidité en flexion du raidisseur, sans ajouter trop de poids.

Le revêtement peut être avantageusement résistant.

Le raidisseur est ainsi configuré pour permettre une rigidité en flexion, sans nécessairement de rigidité en traction, tout en conservant une grande légèreté.

La rigidité en flexion est de préférence élevée, étant notamment supérieure à 1 GPa, voire supérieure à 3 GPa, mieux supérieure à 5 GPa, voire supérieure à 7 GPa, voire encore supérieure à 10 GPa.

L'âme peut être en section transversale de forme générale choisie dans la liste suivante, qui n'est pas limitative : polygonale, rectangulaire, triangulaire, circulaire, semi-circulaire, elliptique, squircles, triangle de Reuleaux, cette liste n'étant pas limitative.

La masse volumique de l'âme peut être inférieure à 500kg/m3, voire inférieure à 400kg/m3, mieux inférieure à 300kg/m3, voire encore inférieure à 200kg/m3, étant par exemple d'environ 100kg/m3.

Les propriétés mécaniques de l'âme sont de préférence conservées jusqu'à une température d'au moins 120°C, voire d'au moins 130°C, mieux d'au moins 140°C, voire encore d'au moins 150°C, par exemple d'environ 160°C.

L'âme peut être configurée pour ne pas s'écraser sous la pression du laminateur permettant d'effectuer l'étape de lamination lors de la fabrication du module photovoltaïque. La pression peut être d'au moins 300 mbar, voire d'au moins 600 mbar, mieux d'au moins 700 mbar, voire encore d'au moins 800 mbar, étant par exemple d'environ 1 bar.

L'âme peut avoir une structure alvéolaire comme un nid d'abeille, par exemple en aluminium ou d'autres matériaux métalliques, cuivre, acier par exemple, cette liste n'étant pas limitative.

Le revêtement du raidisseur peut être en section transversale de forme générale choisie dans la liste suivante, qui n'est pas limitative : polygonale, rectangulaire, triangulaire, circulaire, cette liste n'étant pas limitative.

Le revêtement peut être réalisé dans un matériau composite. Le revêtement peut comporter des fibres noyées dans une matrice en résine polymère.

Les fibres peuvent par exemple être choisies dans la liste suivante, qui n'est pas limitative : fibres de verre, fibres de carbone, fibres d'aramide, fibres naturelles, fibres de chanvre, fibres de lin, fibres de basalte, fibres de carbure de silicium, fibres de polyester.

La matrice peut par exemple être choisie dans la liste suivante, qui n'est pas limitative : matière plastique, polyréthane (PU), polypropylène (PP), époxy, polycarbonate (PC), polyméthacrylate de méthyle (PMMA), polytéréphtalate d'éthylène (PET), polyamide (PA), polyétheréthercétone (PEEK), colle acrylique, silicone, colle époxy, polymère fluoré, polyfluorure de vinyle (PVF), polyfluorure de vinylidène (PVDF), éthylène tétrafluoroéthylène (ETFE), éthylène chlorotrifluoroéthylène (ECTFE), polytétrafluoroéthylène (PTFE), polychlorotrifluoroéthylène (PCTFE) et/ou éthylène propylène fluoré (FEP).

Le matériau composite du revêtement peut posséder une forte rigidité en tension, notamment supérieure à 10 GPa ou plus.

Les propriétés mécaniques du revêtement sont de préférence conservées jusqu'à une température d'au moins 120°C, voire d'au moins 130°C, mieux d'au moins 140°C, voire encore d'au moins 150°C, par exemple d'environ 160°C.

Le matériau composite du revêtement peut avoir un coefficient de dilatation thermique inférieur à 2.10-5 K-1, mieux inférieur à 1,8.10-5 K-1, voire inférieur à 1,4.10-5 K-1, étant par exemple inférieur à 1.10-5 K-1.

Il peut s'agit d'un composite carbone par exemple.

La structure du raidisseur peut être symétrique, notamment avec une symétrie par rapport à un plan, étant notamment symétrique par rapport à ses plans médians vertical et/ou horizontal.

L'épaisseur du raidisseur peut être comprise entre 0,5 mm et 50 mm, mieux entre 1 mm et 40 mm, voire entre 1,5 mm et 30 mm, voire encore entre 1,7 mm et 25 mm, étant par exemple comprise entre 2 et 20 mm.

L'épaisseur h2 de l'âme peut être comprise entre 0,4 mm et 25 mm, mieux entre 1 mm et 20 mm, voire entre 2 mm et 15 mm, voire encore entre 3 mm et 12 mm, étant par exemple d'environ 3 mm.

L'épaisseur h1 du revêtement peut être comprise entre 25 µm et 2 mm, mieux entre 35 µm et 1 mm, voire entre 40 µm et 700 µm, voire encore entre 50 µm et 500 µm, étant par exemple d'environ 100 µm.

Dans une autre variante de réalisation, le ou les raidisseurs sont monocouches, ne comportant qu'une seule couche de matériau composite, dont les fibres et la matrice peuvent être issues des mêmes familles de matériaux que le matériau composite des raidisseurs à âme avec revêtement, tel que décrit précédemment. Cette monocouche peut avoir une épaisseur h3 qui peut être comprise entre 50 µm et 1 000 µm, mieux entre 100 µm et 900 µm, voire entre 200 µm et 700 µm, voire encore entre 300 µm et 600 µm, étant par exemple d'environ 500 µm.

Un tel raidisseur peut respecter les mêmes propriétés mécaniques du revêtement des raidisseurs à âme avec revêtement, tel que décrit précédemment.

Une telle structure de raidisseur est particulièrement efficace en complément d'une couche de renforcement, notamment en matériau composite, en face arrière, car dans ce cas, ce sont les couches intermédiaires du module photovoltaïque, l'ensemble encapsulant notamment, qui jouent le rôle d'âme.

Dans une autre variante de réalisation encore, le ou les raidisseurs peuvent comporter une âme très fine. L'épaisseur h2 de l'âme peut être comprise entre 50 µm et 1 000 µm, mieux entre 80 µm et 800 µm, voire entre 100 µm et 600 µm, voire encore entre 1500 µm et 400 µm, étant par exemple d'environ 200 µm.

Cette âme très fine peut avoir une bonne rigidité en tension, étant notamment supérieure à 1 GPa, voire supérieure à 3 GPa, mieux supérieure à 5 GPa, voire supérieure à 7 GPa, voire encore supérieure à 10 GPa.

Cette âme très fine peut avoir un coefficient de dilatation thermique inférieur à 2.10-5 K-1, mieux inférieur à 1,8.10-5 K-1, voire inférieur à 1,4.10-5 K-1, étant par exemple inférieur à 1.10-5 K-1.

La finesse de cette âme très fine fait que le critère de légèreté exprimé pour l'âme du raidisseur à âme avec revêtement n'est ici pas indispensable. Le kovar ou l'invar sont des exemples de métaux utilisables.

Les cellules photovoltaïques peuvent comporter du silicium, notamment du silicium multi- ou monocristallin. De telles cellules peuvent être moins coûteuses. L'utilisation de ces cellules peut ainsi permettre d'obtenir un module photovoltaïque à bas coût, ce qui peut notamment être avantageux dans le cas où le module photovoltaïque est destiné à une utilisation dans une constellation de satellites, qui peuvent être très nombreux.

Le module photovoltaïque peut dans un mode de réalisation être dépourvu de matériaux rares et onéreux comme par exemple des cellules faites à partir de matériaux dits III-V. Il peut par exemple être dépourvu de face arrière sous forme de sandwich alliant nid d'abeille en aluminium et composites carbones.

Les cellules photovoltaïques d'une guirlande peuvent être disposées en tuiles. Par 'disposées en tuiles', il faut comprendre que les cellules sont connectées les unes aux autres au moyen d'un accolement des bords de cellules, notamment par un joint électrique, par exemple une colle ECA (en anglais *'Electrically Conductive Adhesive*'). Une telle configuration en tuiles est appelée *'string shingle'* en anglais.

L'invention permet avantageusement le renforcement du module photovoltaïque, même pour un module comportant des cellules photovoltaïques disposées en tuiles.

La face avant peut être définie par une première couche de protection transparente réalisée à base de verre ou d'un ou des polymères, choisis dans la liste suivante, qui n'est pas limitative : polyuréthane (PU), polypropylène (PP), époxy, polycarbonate (PC), polyméthacrylate de méthyle (PMMA), polytéréphtalate d'éthylène (PET), polyamide (PA), polyimide (PI), polyétheréthercétone (PEEK), polymère fluoré, notamment polyfluorure de vinyle (PVF), polyfluorure de vinylidène (PVDF), éthylène tétrafluoroéthylène (ETFE), éthylène chlorotrifluoroéthylène (ECTFE), polytétrafluoroéthylène (PTFE), polychlorotrifluoroéthylène (PCTFE) et/ou éthylène propylène fluoré (FEP).

La face arrière peut être définie par une deuxième couche de protection, transparente ou non, réalisée à base d'un ou des polymères, choisis dans la liste qui précède.

La face avant peut être définie par une première couche de protection transparente, une épaisseur de la première couche de protection étant comprise entre 5 µm et 500 µm, voire comprise entre 6 µm et 400 µm, voire encore comprise entre 7 µm et 300 µm, mieux comprise entre 8 µm et 200 µm, encore mieux comprise entre 9 µm et 100 µm, voire entre 10 µm et 80 µm, étant notamment comprise entre 12 et 50 µm.

La face arrière peut être définie par une deuxième couche de protection, transparente ou non, une épaisseur de la deuxième couche de protection étant comprise entre 5 µm et 500 µm, voire comprise entre 6 µm et 400 µm, voire encore comprise entre 7 µm et 300 µm, mieux comprise entre 8 µm et 200 µm, encore mieux comprise entre 9 µm et 100 µm, voire entre 10 µm et 80 µm, étant notamment comprise entre 12 et 50 µm.

Dans une autre variante de réalisation, la face arrière peut être définie par une deuxième couche de protection, transparente ou non, en verre. Une épaisseur de la deuxième couche de protection en verre peut être comprise entre 10 µm et 1000 µm, voire comprise entre 20 µm et 800 µm, voire encore comprise entre 30 µm et 600 µm, mieux comprise entre 40 µm et 400 µm, encore mieux comprise entre 50 µm et 300 µm, voire entre 60 µm et 200 µm, étant notamment de l'ordre de 100 µm.

En variante encore, la face avant définie par la première couche de protection et/ou la face arrière définie par la deuxième couche de protection peuvent être composées d'un assemblage de plusieurs matériaux choisis parmi : verre, polymère, composés hybrides, cette liste n'étant pas limitative.

La masse surfacique du module photovoltaïque peut être inférieure à 3 kg/m², voire inférieure à 2 kg/m², voire encore inférieure à 1 kg/m².

### Générateur photovoltaïque solaire et objet spatial

L'invention a encore pour objet, indépendamment ou en combinaison avec ce qui précède, un générateur photovoltaïque solaire comportant un ou plusieurs modules photovoltaïques tels que décrits plus haut.

Le générateur photovoltaïque solaire peut être conçu pour une application terrestre ou en variante pour une application extraterrestre, notamment spatiale.

L'invention a ainsi pour objet un générateur photovoltaïque solaire pour application extraterrestre, notamment spatiale, comportant un ou plusieurs modules photovoltaïques tels que décrits plus haut.

L'invention a encore pour objet, indépendamment ou en combinaison avec ce qui précède, un objet spatial comportant un générateur photovoltaïque solaire pour application extraterrestre, notamment spatiale, tel que décrit ci-dessus.

L'objet spatial peut être choisi dans la liste suivante, qui n'est pas limitative : avion, drone, dirigeable, aéronef stratosphérique, satellite, satellite terrestre, satellite d'orbite basse, base lunaire, base martienne. L'objet spatial peut notamment être configuré pour être utilisé sur une orbite basse terrestre, par exemple inférieure à 2000 km.

### Procédé de fabrication

Le ou les raidisseurs selon l'invention peuvent être mis en place dès la fabrication du module photovoltaïque.

L'invention a ainsi pour objet, indépendamment ou en combinaison avec ce qui précède, un procédé de fabrication d'un module photovoltaïque, notamment tel que défini ci-dessus,
procédé dans lequel on fournit un empilement comportant une face avant et une face arrière entre lesquelles est disposé un ensemble encapsulant de cellules photovoltaïques, avec une pluralité de guirlandes chacune d'une ou plusieurs cellules photovoltaïques, la ou les cellules photovoltaïques d'une guirlande étant placées en série selon un axe longitudinal de la guirlande,
procédé dans lequel on vient disposer, avant lamination de l'empilement, une pluralité de raidisseurs entre la face avant et la face arrière, avec au moins un raidisseur longitudinal placé entre les guirlandes de cellules photovoltaïques, de manière à s'étendre longitudinalement entre deux guirlandes de cellules photovoltaïques, avant lamination de l'empilement.

On vient ensuite laminer l'empilement, ce qui permet d'assurer le maintien de toutes les couches de l'empilement et leur bonne cohésion.

L'étape de lamination est configurée pour permettre la cohésion des raidisseurs entre eux, notamment par thermocollage. Ainsi, les raidisseurs acquièrent une continuité qui permet de renforcer le module photovoltaïque.

En variante, les raidisseurs peuvent être déjà solidaires les uns des autres avant l'étape de lamination, étant par exemple découpés solidairement les uns des autres.

Le ou les raidisseurs peuvent être disposés entre la face avant et l'ensemble encapsulant. Le cas échéant, un ou des raidisseurs parmi la pluralité de raidisseurs peuvent être disposés entre l'ensemble encapsulant et la face arrière.

Après lamination, la face avant et/ou la face arrière peuvent venir suivre les reliefs créés par les raidisseurs présents entre la face avant et l'ensemble encapsulant et/ou entre l'ensemble encapsulant et la face arrière.

Par ailleurs, au moins un raidisseur transversal peut être disposé transversalement aux guirlandes de cellules photovoltaïques.

### Brève description des dessins

L'invention pourra être mieux comprise à la lecture de la description détaillée qui va suivre, d'exemples de réalisation non limitatifs de celle-ci, et à l'examen du dessin annexé, sur lequel :
[Fig 1] La figure 1 est une vue en perspective, schématique et partielle, d'un module photovoltaïque.
[Fig 2] La figure 2 est une vue en coupe, schématique et partielle, du module photovoltaïque de la figure 1.
[Fig 3] La figure 3 est une vue en coupe, schématique et partielle, d'un module photovoltaïque selon l'invention.
[Fig 4] La figure 4 est une vue en coupe, schématique et partielle, du module photovoltaïque de la figure 3 avant lamination.
[Fig 5] La figure 5 est une vue de dessus, schématique et partielle, du module photovoltaïque de la figure 3.
[Fig 6] La figure 6 est une vue en coupe, schématique et partielle, d'une variante de réalisation de module photovoltaïque avant lamination.
[Fig 7] La figure 7 est une vue en coupe, schématique et partielle, d'une variante de réalisation de module photovoltaïque.
[Fig 8] La figure 8 est une vue de dessus et de détails, schématique et partielle, du module photovoltaïque de la figure 3.
[Fig 9] La figure 9 est une vue de dessus et de détails, schématique et partielle, du module photovoltaïque de la figure 3.
[Fig 10] La figure 10 est une vue en coupe, schématique et partielle, du module photovoltaïque de la figure 3.
[Fig 11] La figure 11 est une vue analogue à la figure 8 de variantes de réalisation.
[Fig 12] La figure 12 est une vue analogue à la figure 5 d'une variante de réalisation.
[Fig 13] La figure 13 est une vue analogue à la figure 5 d'une variante de réalisation.
[Fig 14] La figure 14 est une vue analogue à la figure 5 d'une variante de réalisation.
[Fig 15] La figure 15 est une vue en section transversale, schématique et partielle, d'un raidisseur.
[Fig 16] La figure 16 est une vue analogue à la figure 15 de variantes de réalisation de raidisseur.
[Fig 17] La figure 17 est une vue analogue à la figure 15 d'une variante de réalisation de raidisseur.

### Description détaillée

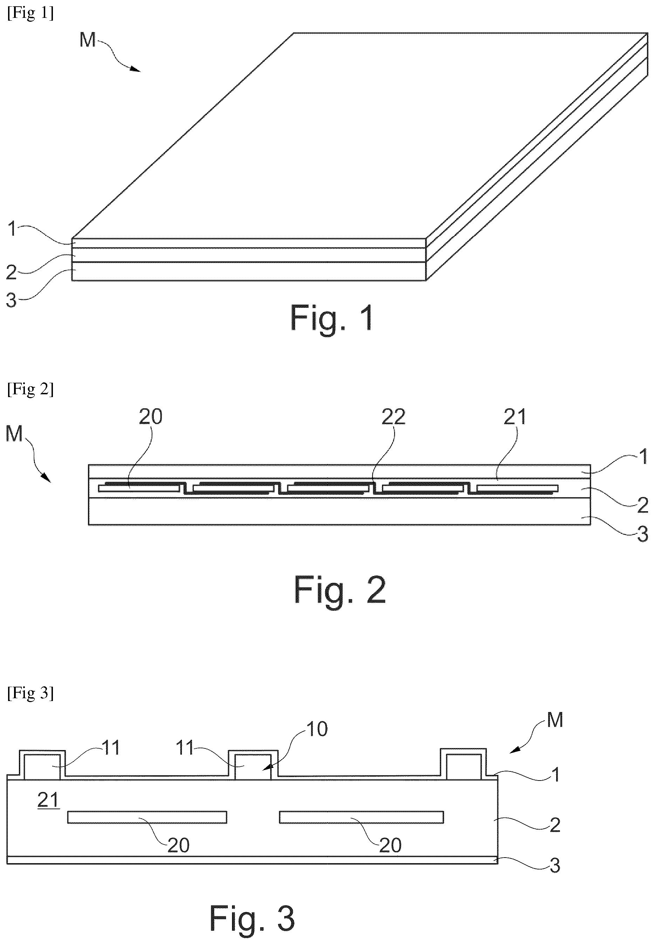

On a illustré aux figures 1 et 2 un module photovoltaïque M comportant plusieurs couches superposées et assemblées entre elles :
- Une première couche de protection 1 en face avant ; cette première couche de protection 1 est habituellement en verre, par exemple en verre trempé transparent d'épaisseur d'environ 3 à 4 mm ou en verre d'épaisseur comprise entre 10 µm et 500 µm. Elle peut en variante être à base de polymères multi-couches et être d'une épaisseur bien inférieure, par exemple comprise entre 12 et 50 µm ;
- Une deuxième couche de protection 3 appelée couramment *"backsheet",* en face arrière ; cette deuxième couche 3 est habituellement réalisée à base de polymères multi-couches ou en verre trempé comme la première couche de protection 1 ; elle peut être opaque ou transparente, monocouche ou multicouche ;
- Une couche intermédiaire 2, intercalée entre la première couche 1 et la deuxième couche 3, permettant l'assemblage d'un côté de la première couche de protection 1 et de l'autre côté de la deuxième couche de protection 3 ; cette couche intermédiaire comportant des cellules photovoltaïques 20, la connectique électrique 22 et un ensemble encapsulant 21 arrangé autour des cellules photovoltaïques.

Dans la suite de la description, la face avant du module photovoltaïque M correspond à une face du module recevant les rayons lumineux et la face arrière correspond à la face opposée à la face avant. Les deux couches de protection 1 et 3 peuvent présenter une fonction de rigidification et/ou une fonction de protection de surface.

La deuxième couche 3 peut notamment assurer une fonction d'imperméabilité aux gaz et à l'eau, une fonction de protection/isolation électrique et une fonction de protection mécanique. Cette deuxième couche 3 peut être réalisée à base d'un polymère fluoré. Il peut s'agir du polyfluorure de vinyle (PVF), par exemple commercialisé sous le nom TEDLAR (marque déposée) par la société DuPont (marque déposée). De manière non limitative, la première couche 1 peut elle-même être composée d'un empilement de plusieurs strates : une strate de PVF, une strate en PET (poly(téréphtalate) d'éthylène), une strate de PVF.

Dans la couche intermédiaire 2, l'ensemble encapsulant 21 est classiquement réalisé dans un matériau polymère, par exemple de type élastomère transparent, dans lequel est encapsulé ou enrobé au moins un élément électriquement ou optiquement actif, tels que des cellules photovoltaïques. Il peut s'agir d'un polymère tel que de l'EVA (Ethylène-Acétate de Vinyl) formant un matériau sur lequel peuvent adhérer la première couche 1 d'un côté et la deuxième couche 3 de l'autre côté et permettre l'assemblage des trois couches entre elles.

Les trois couches peuvent être assemblées entre elles par laminage à chaud, de sorte que la première couche et la deuxième couche viennent adhérer au matériau de l'ensemble encapsulant 21, formant ainsi un empilement monobloc.

Dans la couche intermédiaire 2, les cellules photovoltaïques 20 comportent du silicium, notamment du silicium multi ou monocristallin, et sont connectées entre elles, en série/parallèle, formant plusieurs guirlandes *("string"* en anglais) de cellules. Des éléments de connexion électrique 22, par exemple en cuivre, permettent d'assurer les liaisons électriques entre les cellules 20 dans chaque chaîne.

Les cellules photovoltaïques d'une guirlande sont disposées en tuiles, étant connectées les unes aux autres au moyen d'un accolement des bords de cellules, notamment par un joint électrique, par exemple une colle ECA.

Dans l'exemple décrit en référence aux figures 3 à 5, le module photovoltaïque comporte huit guirlandes de cellules 20, disposées en deux rangées de quatre guirlandes. Bien entendu, une telle configuration n'est pas limitative, et le module photovoltaïque pourrait comporter un nombre différent de rangées et un nombre différentes de guirlandes par rangée. Les cellules photovoltaïques d'une guirlande sont placées en série selon un axe longitudinal de la guirlande X.

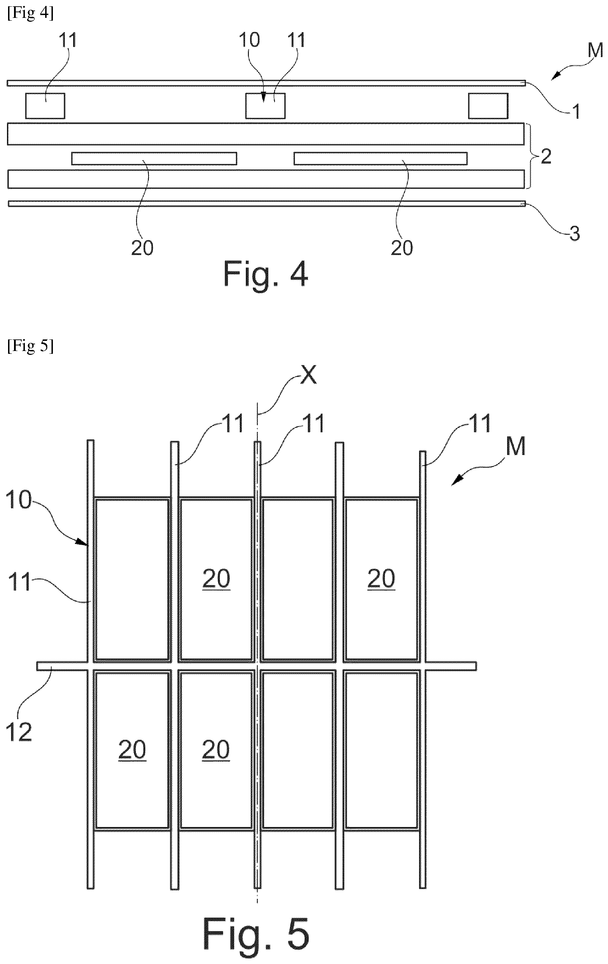

L'empilement comporte en outre selon l'invention une pluralité 10 de raidisseurs disposés entre la face avant et la face arrière, plus précisément disposés entre la face avant et l'ensemble encapsulant, comme illustré aux figures 3 et 4.

Comme illustré schématiquement sur la figure 4, les raidisseurs selon l'invention sont mis en place dès la fabrication, avant lamination de l'empilement. On vient ensuite laminer l'empilement, ce qui permet d'assurer le maintien de toutes les couches de l'empilement et leur bonne cohésion. L'étape de lamination est configurée pour permettre la cohésion des raidisseurs entre eux, notamment par thermocollage. Ainsi, les raidisseurs acquièrent une continuité qui permet de renforcer le module photovoltaïque M.

Après lamination, la face avant et/ou la face arrière peuvent venir suivre les reliefs créés par les raidisseurs présents entre la face avant et l'ensemble encapsulant et/ou entre l'ensemble encapsulant et la face arrière, comme illustré sur la figure 3.

La pluralité de raidisseurs comporte dans cet exemple, comme illustré à la figure 5, cinq raidisseurs longitudinaux 11 placé entre les guirlandes de cellules photovoltaïques 20, de manière à s'étendre longitudinalement entre deux guirlandes de cellules photovoltaïques 20, selon l'axe X.

Les raidisseurs longitudinaux 11 sont allongé en forme de poutre, étant très rigide en flexion.

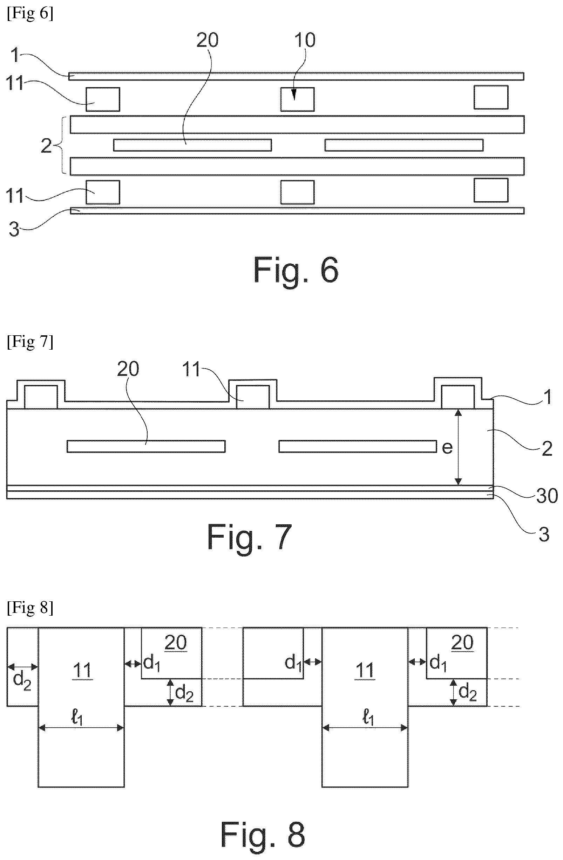

Dans une variante de réalisation illustrée à la figure 6, des raidisseurs longitudinaux 11 de la pluralité de raidisseurs 10 sont également disposés entre l'ensemble encapsulant et la face arrière. Ainsi, le module M de la figure 6 comporte à la fois d'une part des raidisseurs longitudinaux 11 disposés entre la face avant et l'ensemble encapsulant et d'autre part des raidisseurs longitudinaux 11 disposés entre l'ensemble encapsulant et la face arrière, étant disposés de manière symétrique les uns des autres par rapport à un plan de symétrie passant par l'ensemble encapsulant. Il est à noter que les raidisseurs longitudinaux 11 disposés entre l'ensemble encapsulant et la face arrière sont superposés avec les raidisseurs longitudinaux 11 disposés entre la face avant et l'ensemble encapsulant.

Dans une autre variante de réalisation illustrée à la figure 7, le module photovoltaïque M est dépourvu de raidisseurs longitudinaux disposés entre l'ensemble encapsulant et la face arrière, mais comporte une couche de renforcement 30 additionnelle en matériaux composites disposée entre l'ensemble encapsulant 2 et la face arrière 3. Un écartement maximal e entre les raidisseurs 11 et la couche de renforcement 30 est d'environ 10 mm. En variante, le module photovoltaïque M pourrait être dépourvu de deuxième couche de raidisseur, comportant par exemple des raidisseurs entre l'ensemble encapsulant et la face arrière avec également une couche de renforcement disposée entre l'encapsulant 2 et la face arrière.

Comme visible sur la figure 5, la pluralité de raidisseurs 10 comporte d'une part des raidisseurs longitudinaux disposés entre deux guirlandes adjacentes, ainsi que deux raidisseurs longitudinaux disposés entre une ou des guirlandes et un bord du module photovoltaïque M. Ainsi, une distance d1 entre une guirlande et le raidisseur adjacent, mesurée dans le plan du module photovoltaïque, est par exemple de l'ordre de 2 mm, comme illustré sur la figure 8.

De même, une distance d2 entre le bord du module photovoltaïque et les bords des raidisseurs longitudinaux d'extrémité est par exemple de l'ordre de 3 mm.

La largeur 11 d'un raidisseur peut être d'environ 20 mm.

La largeur est avantageusement suffisamment importante pour permettre aux raidisseurs d'apporter de la rigidité au module photovoltaïque, sans toutefois faire perdre une trop grande surface au module photovoltaïque. La surface occupée par les raidisseurs peut ne pas excéder 40% de la surface du module photovoltaïque.

Par ailleurs, le ou les raidisseurs, longitudinaux ou transversaux, peuvent dépasser ou ne pas dépasser de l'ensemble encapsulant.

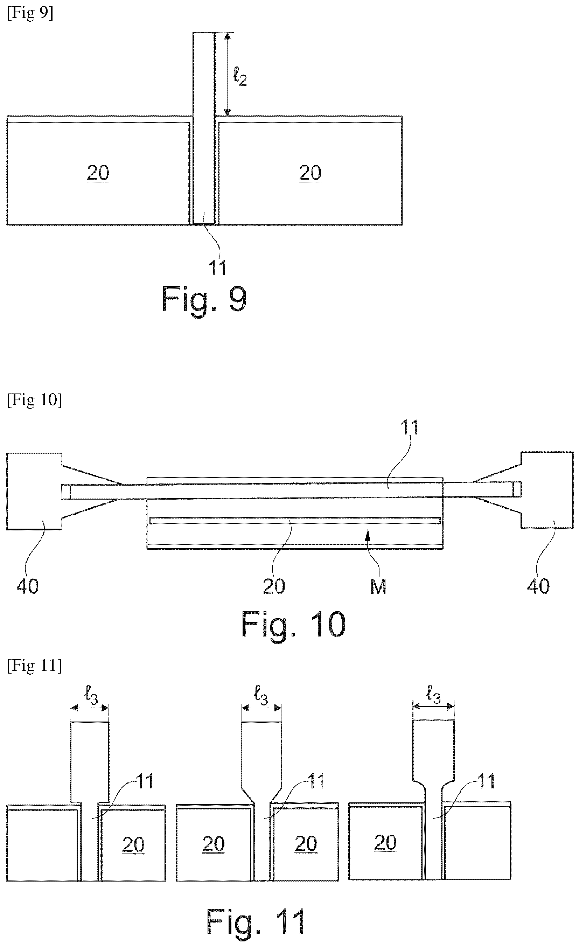

A titre d'exemple, on a illustré à la figure 9 un raidisseur 11 dépassant de l'ensemble encapsulant par une longueur 12 par exemple d'environ 50 mm.

Le dépassement des raidisseurs peut permettre de faciliter la fixation du module photovoltaïque à une structure d'attache 40, comme illustré à la figure 10.

La largeur d'un raidisseur peut varier dans la portion qui dépasse des couches de protection, la largeur peut notamment augmenter. On définit alors 13 la largeur du raidisseur hors des couches de protection. Cette largeur 13 peut être d'environ 5 cm. L'augmentation de la largeur peut se faire via différentes géométries, notamment respectivement avec un angle droit, un biseau ou un congé, comme illustré à la figure 11.

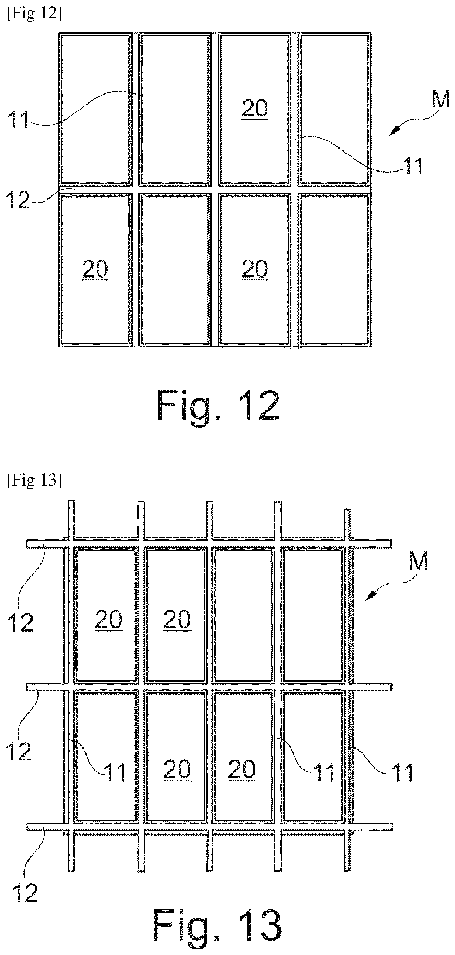

En variante, il peut ne pas y avoir de dépassement, comme illustré sur la figure 12. Dans ce cas, les raidisseurs affleurent au niveau de l'ensemble encapsulant.

Par ailleurs, comme visible sur la figure 5 déjà décrite, le module photovoltaïque M comporte un raidisseur transversal 12. En variante, il peut en comporter plusieurs, comme visible sur la figure 13, dans lequel le module photovoltaïque M comporte trois raidisseurs transversaux 12 disposés transversalement aux guirlandes de cellules photovoltaïques, qui s'étendent perpendiculairement aux raidisseurs longitudinaux 11. Dans le cas où le nombre de rangées de guirlande de cellules photovoltaïques serait supérieur à 2, le nombre de raidisseurs transversaux peut être supérieur à 3.

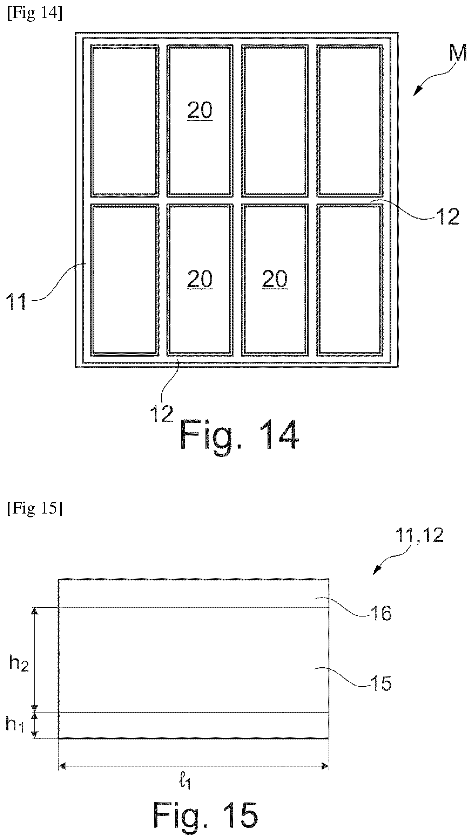

Le ou les raidisseurs transversaux peuvent dépasser ou ne pas dépasser de l'ensemble encapsulant, comme illustré respectivement sur les figures 13 et 14.

En outre, la pluralité de raidisseurs 10 comporte d'une part un raidisseur transversal 12 disposés entre des guirlandes adjacentes, et d'autre part deux raidisseurs transversaux 12 disposés entre des guirlandes et un bord du module photovoltaïque M, comme illustré sur les figures 13 et 14.

Dans un exemple de réalisation illustré à la figure 15, un raidisseur 11, 12 comporte une âme 15 réalisée dans un matériau léger, l'âme étant recouverte d'un revêtement 16 avantageusement résistant, notamment dans un matériau composite.

L'épaisseur h1 du revêtement peut être d'environ 100 µm. L'épaisseur h2 de l'âme peut être d'environ 10 ou 20 mm. L'épaisseur h1 + 2*h2 du raidisseur peut être comprise entre 2 et 20 mm.

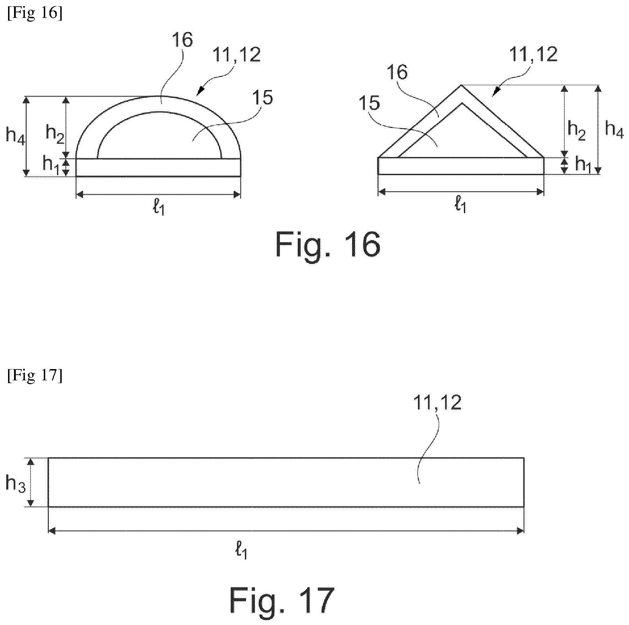

L'âme 16 peut être en section transversale de forme générale choisie dans la liste suivante, qui n'est pas limitative : circulaire, polygonale, rectangulaire, comme illustré à la figure 15, triangulaire ou semi-circulaire, comme illustré à la figure 16.

Un raidisseur 11, 12 peut être en section transversale de forme générale circulaire, polygonale, notamment rectangulaire comme illustré à la figure 15, triangulaire ou semi-circulaire, comme illustré à la figure 16.

Dans les modes de réalisation de la figure 16, les raidisseurs gardent leur structure sandwich avec des revêtements 16 en matériaux composites, mais l'âme 15 n'a plus une forme de pavé droit ou rectangulaire, mais peut prendre des formes plus atypique, respectivement en demi-cône ou semi-circulaire d'une part, et d'autre en part triangulaire ou en pyramide.

De telles âmes peuvent être mises en forme par impression 3D avec des filaments éventuellement enrichis en fibre, comme des filaments en nylon renforcé avec des fibres de carbone, en PA12 renforcé avec des fibres de carbone, en polytéréphtalate d'éthylène renforcé avec des fibres de carbone, en polycarbonate renforcé avec des fibres de carbone, ou en PEKK-A renforcé avec des fibres de carbone.

Dans les structures illustrées à la figure 16, le raidisseur garde une base plate de section rectangulaire d'épaisseur h1 comprise entre 50 µm et 2 mm. Le reste de la structure sandwich, de hauteur h4 comprise entre 0,5 mm et 50 mm, idéalement 20 mm, possède une âme de section en demi-ovale ou triangle ainsi qu'un revêtement supérieur venant recouvrir cette âme. Le revêtement et l'âme possèdent les mêmes caractéristiques que le raidisseur de la figure 15.

Une forme allant en s'amincissant peut permettre de faciliter l'insertion du raidisseur et son intégration dans le module photovoltaïque. En effet, une telle forme peut permettre que la face avant ou arrière fasse bien le tour du raidisseur, ce qui apporte un adoucissement de la transition entre les zones avec et sans raidisseurs et une meilleure répartition des contraintes.

La structure du raidisseur peut être symétrique, avec une symétrie par rapport à ses plans médians vertical et horizontal.

Dans une autre variante de réalisation illustrée à la figure 17, le ou les raidisseurs sont monocouches, ne comportant qu'une seule couche de matériau composite, dont les fibres et la matrice peuvent être issues des mêmes familles de matériaux que le matériau composite des raidisseurs à âme avec revêtement, tel que décrit précédemment. Cette monocouche peut avoir une épaisseur h3 qui peut être d'environ 500 µm.

## Revendications

1. Module photovoltaïque (M) comportant une face avant (1) et une face arrière (3) entre lesquelles est disposé un ensemble encapsulant (2) des cellules photovoltaïques (20),
le module (M) comportant une pluralité de guirlandes chacune de plusieurs cellules photovoltaïques (20), les cellules photovoltaïques (20) d'une guirlande étant placées en série selon un axe longitudinal de la guirlande,
le module (M) comportant en outre une pluralité (10) de raidisseurs (11, 12) disposés entre la face avant (1) et la face arrière (3),
la pluralité (10) de raidisseurs comportant au moins un raidisseur longitudinal (11) placé entre les guirlandes de cellules photovoltaïques (20), de manière à s'étendre longitudinalement entre deux guirlandes de cellules photovoltaïques (20), et
un ou des raidisseurs transversaux (12) disposés entre une ou des guirlandes et un bord du module photovoltaïque,
la pluralité (10) de raidisseurs comportant au moins un raidisseur longitudinal (11) et/ou un des raidisseur transversaux (12) dépassant le module (M).

2. Module photovoltaïque selon l'une quelconque des revendications précédentes, un ou des raidisseurs (11, 12) parmi la pluralité (10) de raidisseurs étant disposés entre la face avant (1) et l'ensemble encapsulant (2), notamment un ou des raidisseurs longitudinaux parmi la pluralité de raidisseurs étant disposés entre la face avant et l'ensemble encapsulant.

3. Module photovoltaïque selon l'une quelconque des revendications précédentes, un ou des raidisseurs (11, 12) parmi la pluralité (10) de raidisseurs étant disposés entre l'ensemble encapsulant (2) et la face arrière (3), notamment un ou des raidisseurs longitudinaux parmi la pluralité de raidisseurs étant disposés entre l'ensemble encapsulant et la face arrière.

4. Module photovoltaïque selon la revendication 2 et la revendication 3, un ou des raidisseurs, notamment longitudinaux, parmi le ou les raidisseurs, notamment longitudinaux, disposés entre l'ensemble encapsulant (2) et la face arrière (3) étant superposés avec le ou les raidisseurs disposés entre la face avant (1) et l'ensemble encapsulant (2).

5. Module photovoltaïque selon l'une quelconque des revendications 1à 3, comportant une couche de renforcement (30), notamment en matériau composite, disposée entre l'ensemble encapsulant (2) et la face arrière (3).

6. Module photovoltaïque selon l'une quelconque des revendications précédentes, comportant un ou des raidisseurs longitudinaux (11) et/ou transversaux (12) disposés entre une ou des guirlandes et un bord du module photovoltaïque.

7. Module photovoltaïque selon l'une quelconque des revendications précédentes, un raidisseur (11, 12) comportant une âme (15), notamment une âme réalisée dans un matériau léger, l'âme étant notamment recouverte en tout ou en partie d'un revêtement (16), notamment un revêtement dans un matériau composite.

8. Module photovoltaïque selon l'une quelconque des revendications précédentes, les cellules photovoltaïques (20) comportant du silicium, notamment du silicium multi ou monocristallin.

9. Module photovoltaïque selon l'une quelconque des revendications précédentes, les cellules photovoltaïques (20) d'une guirlande étant disposées en tuiles.

10. Module photovoltaïque selon l'une quelconque des revendications précédentes, la face avant (1) étant définie par une première couche de protection transparente réalisée à base de verre ou d'un ou des polymères, choisis dans la liste suivante : polyuréthane (PU), polypropylène (PP), époxy, polycarbonate (PC), polyméthacrylate de méthyle (PMMA), polytéréphtalate d'éthylène (PET), polyamide (PA), polyimide (PI), polyétheréthercétone (PEEK), polymère fluoré, notamment polyfluorure de vinyle (PVF), polyfluorure de vinylidène (PVDF), éthylène tétrafluoroéthylène (ETFE), éthylène chlorotrifluoroéthylène (ECTFE), polytétrafluoroéthylène (PTFE), polychlorotrifluoroéthylène (PCTFE) et/ou éthylène propylène fluoré (FEP).

11. Module photovoltaïque selon l'une quelconque des revendications précédentes, la face avant (1) étant définie par une première couche de protection transparente, une épaisseur de la première couche de protection étant comprise entre 5 µm et 500 µm, voire comprise entre 6 µm et 400 µm, voire encore comprise entre 7 µm et 300 µm, mieux comprise entre 8 µm et 200 µm, encore mieux comprise entre 9 µm et 100 µm, voire entre 10 µm et 80 µm, étant notamment comprise entre 12 et 50 µm.

12. Module photovoltaïque selon l'une quelconque des revendications précédentes, la masse surfacique du module photovoltaïque (M) étant inférieure à 3 kg/m², voire inférieure à 2 kg/m², voire encore inférieure à 1 kg/m².

13. Générateur photovoltaïque solaire pour application extraterrestre, notamment spatiale, comportant un ou plusieurs modules photovoltaïques (M) selon l'une quelconque des revendications précédentes.

14. Objet spatial comportant un générateur photovoltaïque solaire pour application extraterrestre, notamment spatiale, selon la revendication précédente.

15. Procédé de fabrication d'un module photovoltaïque, notamment selon l'une quelconque des revendications 1 à 12,
dans lequel on fournit un empilement comportant une face avant et une face arrière entre lesquelles est disposé un ensemble encapsulant de cellules photovoltaïques, avec une pluralité de guirlandes chacune de plusieurs cellules photovoltaïques, les cellules photovoltaïques d'une guirlande étant placées en série selon un axe longitudinal de la guirlande,
procédé dans lequel on vient disposer, avant lamination de l'empilement, une pluralité de raidisseurs entre la face avant et la face arrière, avec au moins un raidisseur longitudinal placé entre les guirlandes de cellules photovoltaïques, de manière à s'étendre longitudinalement entre deux guirlandes de cellules photovoltaïques, et un ou des raidisseurs transversaux (12) disposés entre une ou des guirlandes et un bord du module photovoltaïque, la pluralité (10) de raidisseurs comportant au moins un raidisseur longitudinal (11) et/ou un des raidisseur transversaux (12) dépassant le module (M) .
